(19) Europäisches Patentamt
European Patent Office
Office européen des brevets

(11) **EP 2 025 208 B1**

(12) **EUROPÄISCHE PATENTSCHRIFT**

(45) Veröffentlichungstag und Bekanntmachung des Hinweises auf die Patenterteilung:
**01.08.2012 Patentblatt 2012/31**

(21) Anmeldenummer: **07729858.6**

(22) Anmeldetag: **04.06.2007**

(51) Int Cl.:
**H05B 41/04** *(2006.01)*　　**H03K 3/53** *(2006.01)*
**H01J 61/00** *(2006.01)*

(86) Internationale Anmeldenummer:
**PCT/EP2007/055470**

(87) Internationale Veröffentlichungsnummer:
**WO 2007/141242 (13.12.2007 Gazette 2007/50)**

(54) **HOCKDRUCKENTLADUNGSLAMPE MIT VERBESSERTER ZÜNDFÄHIGKEIT SOWIE HOCHSPANNUNGSPULSGENERATOR**

HIGH-PRESSURE DISCHARGE LAMP WITH AN IMPROVED STARTING CAPABILITY, AS WELL AS A HIGH-VOLTAGE PULSE GENERATOR

LAMPE À DÉCHARGE À HAUTE PRESSION AVEC APTITUDE À L'ALLUMAGE AMÉLIORÉE ET GÉNÉRATEUR D'IMPULSIONS À HAUTE TENSION

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **08.06.2006　DE 102006026751**

(43) Veröffentlichungstag der Anmeldung:
**18.02.2009 Patentblatt 2009/08**

(73) Patentinhaber: **OSRAM AG**
**81543 München (DE)**

(72) Erfinder:
• **KLOSS, Andreas**
**85579 Neubiberg (DE)**
• **WALTER, Steffen**
**85667 Oberpframmern (DE)**

(56) Entgegenhaltungen:
**EP-A- 0 436 200　　EP-A2- 0 049 465**
**WO-A-03/059025　　US-A- 4 217 468**
**US-A- 5 567 995**

**Beschreibung**

Technisches Gebiet

Die Erfindung geht aus von einer Hochdruckentladungslampe Derartige Lampen sind insbesondere Hochdruckentladungslampen für Allgemeinbeleuchtung oder für fotooptische Zwecke. Die Erfindung betrifft weiterhin einen Hochspannungspulsgenerator, der insbesondere für eine Lampe eingesetzt werden kann.

Stand der Technik

Das Problem der Zündung von Hochdruckentladungslampen wird derzeit dadurch gelöst, dass das Zündgerät in das Vorschaltgerät integriert ist. Nachteilig daran ist, dass die Zuleitungen hochspannungsfest ausgelegt sein müssen.

In der Vergangenheit hat es immer wieder Versuche gegeben, die Zündeinheit in die Lampe zu integrieren. Dabei wurde versucht, sie in den Sockel zu integrieren. Eine besonders effektive und hohe Pulse versprechende Zündung gelingt mittels sog. Spiral-Puls-Generatoren, siehe US-A 3 289 015. Vor längerer Zeit wurden derartige Geräte bei verschiedenen Hochdruckentladungslampen wie Metallhalogenidlampen oder Natriumhochdrucklampen vorgeschlagen, siehe beispielsweise US-A 4 325 004, US-A 4 353 012 und EP 49 465 A2. Sie konnten sich jedoch nicht durchsetzen, weil sie zum einen zu teuer sind. Zum andern ist der Vorteil, sie in den Sockel einzubauen, nicht ausreichend, da das Problem des Zuführens der Hochspannung in den Kolben bleibt. Daher die Wahrscheinlichkeit für Schädigungen der Lampe, seien es Isolationsprobleme oder ein Durchbruch im Sockel, steigt stark an. Bisher übiche Zündgeräte konnten Im allgemeinen nicht über 100 °C erwärmt werden. Die erzeugte Spannung musste dann der Lampe zugeführt werden, was Leitungen und Lampenfassungen mit entsprechender Hochspannungsfestigkeit erfordert, typisch etwa 5 kV.

In üblichen Zündschaltungen wird normalerweise ein Kondensator über einen Schalter, z.B. eine Funkenstrecke, in die Primärwicklung eines Zündtrafos entladen. In der Sekundärwicklung wird dann der gewünschte Hochspannungspuls induziert. Siehe dazu Sturm/ Klein, Betriebsgeräte und Schaltungen für elektrische Lampen, S. 193 bis 195 (6. Auflage 1992).

Darstellung der Erfindung

Die Aufgabe der vorliegenden Erfindung ist es, eine Hochdruckentladungslampe bereitzustellen, deren Zündverhalten gegenüber bisherigen Lampen deutlich verbessert ist und bei der keine Schädigung infolge der Hochspannung zu befürchten ist. Dies gilt insbesondere für Metallhalogenidlampen, wobei das Material des Entladungsgefäßes entweder Quarzglas oder Keramik sein kann.

Diese Aufgabe wird gelöst durch die kennzeichnenden Merkmale des Anspruchs 1.

Besonders vorteilhafte Ausgestaltungen finden sich in den abhängigen Ansprüchen.

Weiterhin ist eine Aufgabe der vorliegenden Erfindung, einen kompakten Hochspannungspulsgenerator anzugeben. Diese Aufgabe wird durch die kennzeichnenden Merkmale des Anspruchs 14 gelöst.

Erfindungsgemäß wird jetzt ein Hochspannungspuls mit mindestens 1,5 kV, der zur Zündung der Lampe notwendig ist, mittels eines speziellen temperaturresistenten Spiral-Puls-Generators erzeugt, der in unmittelbarer Nähe des Entladungsgefäßes im Außenkolben integriert wird. Nicht nur eine Kaltzündung, sondern auch ein Heißwiederzündung ist damit möglich.

Der jetzt verwendete Spiral-Puls-Generator ist insbesondere ein sog. LTCC-Bauteil. Diese Material ist eine spezielle Keramik, die bis 600 °C Temperaturfest gemacht werden kann. Zwar wurde LTCC schon in Zusammenhang mit Lampen verwendet, siehe US 2003/0001519 und US-B 6 853 151. Jedoch wurde es für ganz andere Zwecke bei praktisch kaum temperaturbelasteten Lampen, mit typischen Temperaturen unter 100 °C, eingesetzt. Der besondere Wert der hohen Temperaturstabilität von LTCC in Zusammenhang mit der Zündung von Hochdruckentladungslampen, wie vor allem Metallhalogenidlampen mit Zündproblemen, zu erkennen.

Der Spiral-Puls-Generator ist ein Bauteil, das Eigenschaften eines Kondensators mit denen eines Wellenleiters zur Erzeugung von Zündpulsen mit einer Spannung von mindestens 1,5 kV vereint, Für die Herstellung werden zwei keramische "Grün-Folien" mit metallischer Leitpaste bedruckt und anschließend versetzt zu einer Spirale aufgewickelt und schließlich isostatisch zu einem Formkörper gepresst. Die folgende Co-Sinterung von Metallpaste und keramischer Folie erfolgt an Luft im Temperaturbereich zwischen 800 und 900 °C. Diese Verarbeitung erlaubt einen Einsatzbereich des Spiral-Puls-Generators bis 700 °C Temperaturbelastung. Dadurch kann der Spiral-Puls-Generator in direkter Nähe des Entladungsgefäßes im Außenkolben, aber auch im Sockel oder in unmittelbarer Nähe der Lampe untergebracht werden.

Unabhängig davon kann ein derartiger Spiral-Puls-Generator auch für andere Anwendungen eingesetzt werden, weil er nicht nur hochtemperaturstabil ist, sondern auch äußerst kompakt. Dafür ist wesentlich, dass der Spiral-Puls-Generator als LTCC-Bauteil ausgeführt ist, bestehend aus Keramikfolien und einer metallischen Benetzung auf der Folie, insbesondere in Form einer metallischen Leitpaste. Um ausreichend Ausgangspannung zu liefern, sollte die Spirale mindestens 5 Windungen umfassen.

Zudem lässt sich auf Basis dieses Hochspannungspulsgenerators eine Zündeinheit angeben, die weiterhin zumindest einen Ladewiderstand und einen Schalter umfasst. Der Schalter kann eine Funkenstrecke oder auch ein Diac in SiC-Technologie sein.

Bevorzugt ist im Falle einer Anwendung für Lampen die Unterbringung im Außenkolben. Denn dadurch entfällt die Notwendigkeit einer hochspannungsfesten Spannungszuleitung.

Zudem lässt sich ein Spiral-Puls-Generator so dimensionieren, dass der Hochspannungspuls sogar eine Heißwiederzündung der Lampe ermöglicht. Das Dielektrikum aus Keramik zeichnet sich durch eine außergewöhnlich hohe Dielektrizitätskonstante $\varepsilon$ von $\varepsilon > 10$ aus, wobei je nach Material und Bauweise ein $\varepsilon$ von typisch 70, bis zu $\varepsilon=100$ erreicht werden kann. Das schafft eine sehr hohe Kapazität des Spiral-Puls-Generators und ermöglicht eine vergleichsweise große zeitliche Breite der erzeugten Impulse. Dadurch wird eine sehr kompakte Bauweise des Spiral-Puls-Generators möglich, so dass ein Einbau in handelsübliche Außenkolben von Hochdruckentladungslampen gelingt.

Die große Pulsbreite erleichtert zudem den Durchschlag im Entladungsvolumen.

Als Material des Außenkolbens kann jedes übliche Glas verwendet werden, also insbesondere Hartglas, Vycor oder Quarzglas. Auch die Wahl der Füllung unterliegt keiner besonderen Einschränkung.

Eine besonders einfache Anpassung der gewünschten Eigenschaften eines LTCC-Spiral-Puls-Generators wird erreicht, indem als Dielektrikum nicht einfach ein Material mit gewünschter Dielektrizitätskonstante verwendet wird, sondern eine Mischung aus zwei Materialien, von denen ein erstes Material ein gegebenes epsilon $\varepsilon_r$ und das zweite Material ein gegebenes $\mu_r$, also eine relative Permeabilität, besitzt. Während bisher ein einfaches Material mit einem $\varepsilon$ von 4 bis 1000 verwendet wurde, kann jetzt eine Mischung verwendet werden, bei der das erste Material ein $\varepsilon$ von 2 bis 1000 haben kann, während das zweite Material ferritisch ist und ein $\mu$ von 1 bis 5000 haben kann. Bevorzugt ist $\mu_r$ möglichst hoch, und beträgt mindestens 10, besonders bevorzugt mindestens 100. Bisher lag der Wert von $\mu$ bei den bekannten Materialien nahe bei 1; eine Anpassung war nicht möglich. Eine typische Mischung ist ein Anteil von 5 bis 35 Gew.-% des ferritischen Materials.

Der besondere Wert des neuartigen Freiheitsgrades erschließt sich aus folgender Überlegung:

Für die Anpassung von Pulsbreite, Wellenwiderstand und Pulsenergie eines Spiralpulsgenerators sollte $\mu$ und $\varepsilon$ gemäß folgender Richtschnur gewählt werden : Der Wellenwiderstand (Impedanz) Zo eines Spiralgenerators ist gegeben durch $Z_0 \sim \sqrt{\dfrac{\mu_0 \cdot \mu_r}{\varepsilon_0 \cdot \varepsilon_r}}$

mit $\mu_0$ - Induktionskonstante, $\varepsilon_0$ - Influenzkonstante, $\mu_r$ - relative Permeabilität und $\varepsilon_r$ - relative Dielektrizitätskonstante. Die Energie des erzeugten Pulses ist proportional zu $\sqrt{\varepsilon_r}$ . Die Pulsbreite des Generators $\square$ ist

durch $\tau \sim \sqrt{\mu_0 \cdot \mu_r \cdot \varepsilon_0 \cdot \varepsilon_r}$ gegeben. Für eine effiziente Funktionsweise des Generators muss gelten $Ls \ll (Z_0 \cdot \tau)$ mit $L_s$ - Induktivität des Kurzschlussschalters. Wegen $Z_0 \cdot \tau \sim \mu_r$ lässt sich diese Anpassung an die Induktivität des Kurzschlussschalters über die Wahl der relativen Permeabilität erreichen.

Kurze Beschreibung der Zeichnungen

Im Folgenden soll die Erfindung anhand mehrerer Ausführungsbeispiele näher erläutert werden. Die Figuren zeigen:

Fig. 1      den prinzipiellen Aufbau eines Spiral-Puls-Generators;

Fig. 2      Kenngrößen eines LTCC- Spiral-Puls-Generators;

Fig. 3      den Prinzipaufbau einer Natriumhochdrucklampe mit Spiral-Puls-Generator im Außenkolben.

Fig. 4      den Prinzipaufbau einer Metallhalogenidlampe mit Spiral-Puls-Generator im Außenkolben.

Fig. 5      eine Metallhalogenidlampe mit Spiral-Puls-Generator im Außenkolben;

Fig. 6      eine Metallhalogenidlampe mit Spiral-Puls-Generator im Sockel.

Bevorzugte Ausführungsform der Erfindung

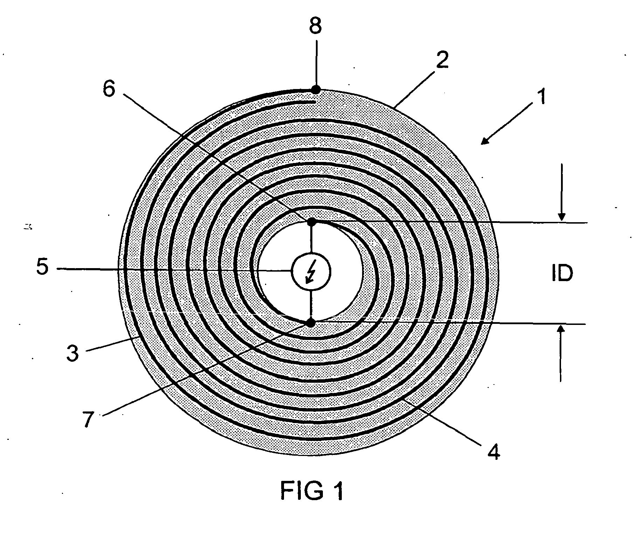

Figur 1 zeigt den Aufbau eines Spiral-Puls-Generators 1 in Draufsicht. Er besteht aus einem keramischen Zylinder 2, in den zwei verschiedene metallische Leiter 3 und 4 als Folienband spiralförmig eingewickelt sind. Der Zylinder 2 ist innen hohl und besitzt einen gegebenen Innendurchmesser ID. Die beiden inneren Kontakte 6 und 7 der beiden Leiter 3 und 4 liegen sich in etwa gegenüber und sind über eine Funkenstrecke 5 miteinander verbunden.

Nur der äußere der beiden Leiter besitzt am äußeren Rand des Zylinders einen weiteren Kontakt 8. Der andere Leiter endet offen. Die beiden Leiter bilden dadurch zusammen einen Wellenleiter in einem dielektrischen Medium, der Keramik.

Der Spiral-Puls-Generator wird entweder aus zwei mit Metallpaste beschichteten keramischen Folien gewickelt oder aus zwei Metallfolien und zwei keramischen Folien aufgebaut. Eine wichtige Kenngröße ist dabei die Zahl n der Windungen, die bevorzugt in der Größenordnung 5 bis 100 liegen soll. Diese Wickelanordnung wird dann laminiert und anschließend gesintert, wodurch ein LTCC-Bauteil entsteht. Die so geschaffenen Spiral-Puls-Generatoren mit Kondensatoreigenschaft werden dann mit einer Funkenstrecke sowie einem Ladewiderstand beschaltet. Die keramische Folie ist hier eine Mischung aus dielektrischem Material mit ε zwischen 2 und 1000 und ferritischem Material mit μ zwischen 1,5 und 5000.

Die Funkenstrecke kann sich an den inneren oder den äußeren Anschlüssen oder auch innerhalb der Wicklung des Generators befinden. Als Hochspannungsschalter, der den Puls initiiert, kann bevorzugt eine Funkenstrecke verwendet werden, die auf SiC basiert und sehr temperaturstabil ist. Beispielsweise kann das Schaltelement MESFET der Fa. Cree verwendet werden. Dieses ist für Temperaturen oberhalb 350 °C geeignet.

In einem konkreten Ausführungsbeispiel wird ein Keramikmaterial mit ε = 60 bis 70 verwendet. Dabei wird bevorzugt als Dielektrikum eine Keramikfolie, insbesondere ein Keramikband wie Heratape CT 707 oder bevorzugt CT 765 oder auch eine Mischung beider, jeweils von Heraeus verwendet. Es hat eine Dicke der grünen Folie von typisch 50 bis 150 μm. Als Leiter wird insbesondere Ag-Leitpaste wie "Cofirable Silver," ebenfalls von Heraeus, verwendet. Ein konkretes Beispiel ist CT 700 von Heraeus. Gute Ergebnisse liefert auch die Metallpaste 6142 von DuPont. Diese Teile lassen sich gut laminieren und danach ausheizen ("burnout") und zusammen sintern ("co-firing").

Der Innendurchmesser ID des Spiral-Puls-Generator ist 10 mm. Die Breite der einzelnen Streifen ist ebenfalls 10 mm. Die Foliendicke ist 50 μm und auch die Dicke der beiden Leiter ist jeweils 50 μm. Die Ladespannung beträgt 300 V. Unter diesen Voraussetzungen erreicht der Spiral-Puls-Generator ein Optimum seiner Eigenschaften bei einer Windungszahl von n = 20 bis 70.

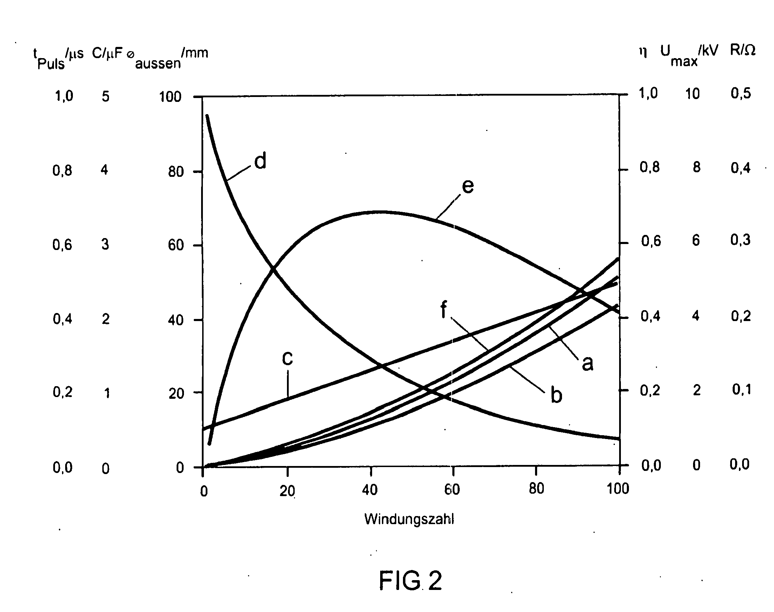

In Figur 2 sind die zugehörige Halbwertsbreite des Hochspannungspulses in μs (Kurve a), die Gesamtkapazität des Bauteils in μF (Kurve b), der resultierende Außendurchmesser in mm (Kurve c), sowie die Effizienz (Kurve d), die maximale Pulsspannung (Kurve e) in kV und der Leiterwiderstand in Q (Kurve f) dargestellt.

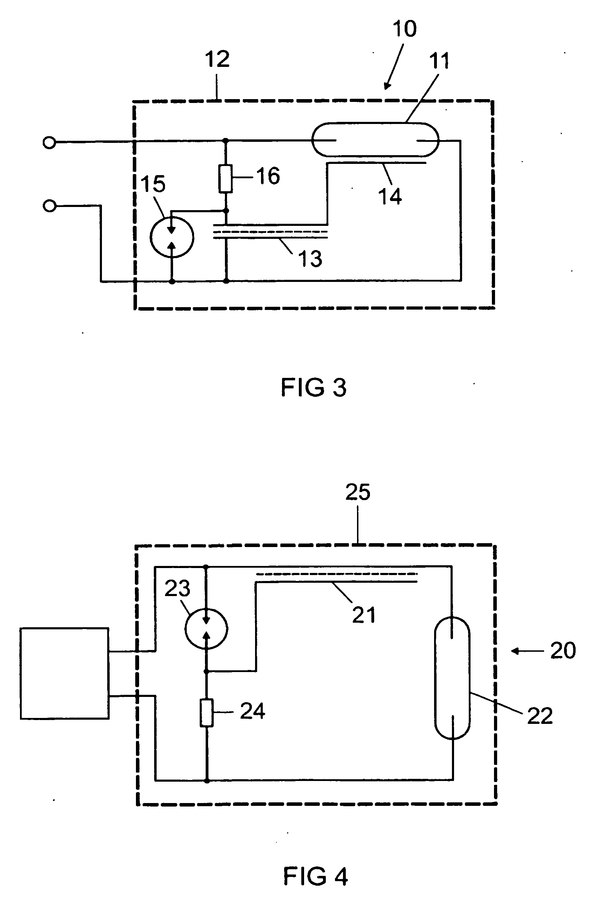

Figur 3 zeigt den prinzipiellen Aufbau einer Natriumhochdrucklampe 10 mit keramischem Entladungsgefäß 11 und Außenkolben 12 mit darin integriertem Spiral-Puls-Generator 13, wobei eine Zünd-Elektrode 14 außen am keramischen Entladungsgefäß 11 angebracht ist. Der Spiral-Puls-Generator 13 ist mit der Funkenstrecke 15 und dem Ladewiderstand 16 im Außenkolben untergebracht.

Figur 4 zeigt den prinzipiellen Aufbau einer Metallhalogenidlampe 20 mit integriertem Spiral-Puls-Generator 21, wobei keine Zünd-Elektrode außen am Entladungsgefäß 22, das aus Quarzglas oder Keramik gefertigt sein kann, angebracht ist. Der Spiral-Puls-Generator 21 ist mit der Funkenstrecke 23 und dem Ladewiderstand 24 im Außenkolben 25 untergebracht.

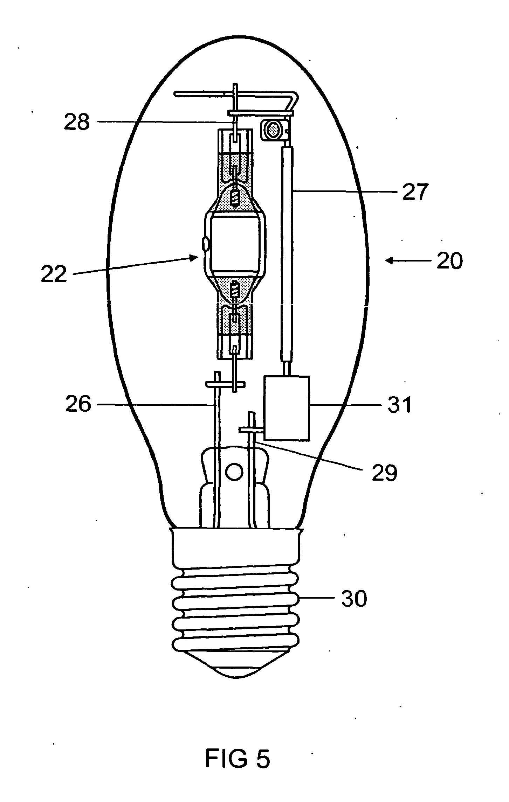

Figur 5 zeigt eine Metallhalogenidlampe 20 mit einem Entladungsgefäß 22, das von zwei Zuleitungen 26, 27 in einem Außenkolben gehalten wird. Die erste Zuleitung 26 ist ein kurz abgewinkelter Draht. Die zweite 27 ist im wesentlichen ein Stab, der zur sockelfernen Durchführung 28 führt. Zwischen der Zuleitung 29 aus dem Sockel 30 und dem Stab 27 ist eine Zündeinheit 31 angeordnet, die den Spiral-Puls-Generator, die Funkenstrecke und den Ladewiderstand enthält, wie in Figur 4 angedeutet.

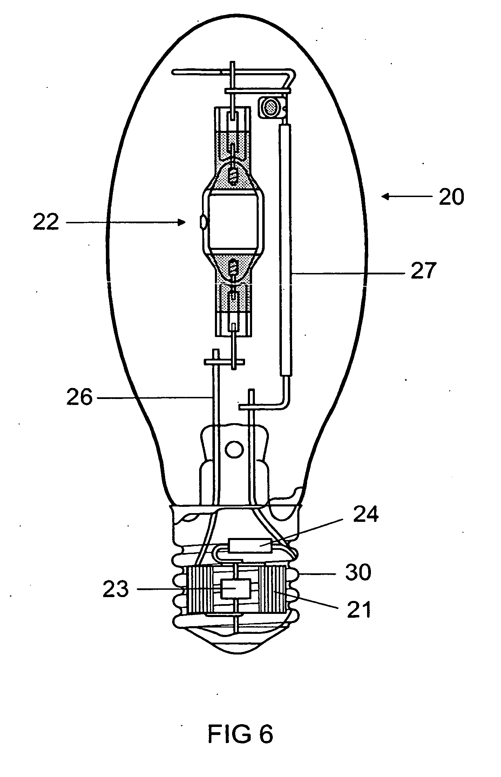

Figur 6 zeigt eine Metallhalogenidlampe 20 ähnlich wie Figur 5 mit einem Entladungsgefäß 22, das von zwei Zuleitungen 26, 27 in einem Außenkolben 25 gehalten wird. Die erste Zuleitung 26 ist ein kurz abgewinkelter Draht. Die zweite 27 ist im wesentlichen ein Stab, der zur sockelfernen Durchführung 28 führt. Hier ist die Zündeinheit im Sockel 30 angeordnet, und zwar sowohl der Spiral-Puls-Generator 21, als auch die Funkenstrecke 23 und der Ladewiderstand 24.

Diese Technik kann auch für elektrodenlose Lampen angewendet werden, wobei der Spiral-Puls-Generator als Zündhilfe dienen kann.

Weitere Anwendungen dieses kompakten Hochspannungspulsgenerators liegen in der Zündung anderer Geräte. Die Anwendung ist vor allem bei sog. magischen Kugeln, bei der Erzeugung von Röntgenpulsen und der Erzeugung von Elektronenstrahl-Pulsen vorteilhaft. Auch ein Einsatz in Kfz als Ersatz für die üblichen Zündspulen ist möglich.

Dabei werden Windungszahlen von n bis 500 verwendet, so dass die Ausgangsspannung bis in die Größenordnung von 100 kV erreicht. Denn die Ausgangsspannung $U_A$ ist als Funktion der Ladespannung $U_L$ gegeben durch $U_A = 2 \times n \times U_L \times \eta$, wobei die Effizienz η durch η = (AD-ID)/AD gegeben ist.

Die Erfindung entfaltet besondere Vorteile im Zusammenwirken mit Hochdruckentladungslampen für Autoscheinwerfer, die mit Xenon unter hohem Druck von bevorzugt mindestens 3 bar und Metallhalogeniden gefüllt sind. Diese sind besonders schwer zu zünden, da wegen des hohen Xenondrucks die Zündspannung mehr als 10 kV beträgt. Derzeit wird versucht, die Komponenten der Zündeinheit im Sockel unterzubringen. Ein Spiral-Puls-Generator mit integriertem Ladewiderstand kann entweder in den Sockel der Kfz-Lampe oder in einen Außenkolben der Lampe untergebracht sein.

Die Erfindung entfaltet ganz besondere Vorteile im Zusammenwirken mit Hochdruckentladungslampen, die kein Quecksilber enthalten. Derartige Lampen sind aus Umweltschutzgründen besonders erstrebenswert. Sei enthalten eine geeignete Metallhalogenid-Füllung und insbesondere ein Edelgas wie Xenon unter hohem Druck. Wegen des fehlenden Quecksilbers ist die Zündspannung besonders hoch. Sie beträgt mehr als 20 kV. Derzeit wird versucht, die Komponenten der Zündeinheit im Sockel unterzubringen. Ein Spiral-Puls-Generator mit integriertem Ladewiderstand kann entweder in den Sockel der quecksilberfreien Lampe oder in einen Außenkolben der Lampe untergebracht sein.

Als zweites Material eignen sich bekannte Ferrite, beispielsweise Eisenoxide. Als Dotierstoff kommt ggf. beispielsweise Mg oder Al in Frage. Andere geeignete Metalloxide sind die des Nickels, Mangans, Magnesiums, Zinks und Kobalts, einzeln oder in Mischung, insbesondere Ni-Zn. Der Anteil des zweiten Materials kann insbesondere mindestens 15 Gew.-% sein. Seine relative Permeabilität sollte mindestens 1,5 betragen.

**Patentansprüche**

1. Hochspannungspulsgenerator auf der Basis eines Spiral-Puls-Generators (1), **dadurch gekennzeichnet, dass** der Spiral-Puls-Generator (1) aus temperaturbeständigem Material, hergestellt ist, wobei dieses Material aus Keramikfolien und aus metallischer Benetzung auf den Folien besteht und wobei das Material der Keramikfolien eine Mischung aus zwei Materialien ist, von denen das erste Material eine Dielektrizitätskonstante $\varepsilon_r$ von 2 bis 1000 hat und das zweite Material eine relative Permeabilität $\mu_r$ von 1 bis 5000 aufweist

2. Hochspannungspulsgenerator nach Anspruch 1, **dadurch gekennzeichnet, dass** die relative Permeabilität des zweiten Materials mindestens $\mu_r = 1,5$ beträgt.

3. Hochspannungspulsgenerator nach Anspruch 1, **dadurch gekennzeichnet, dass** das zweite Material Metalloxid ist, insbesondere mit einem Anteil von mindestens 15 Gew.-% an der keramischen Mischung.

4. Hochspannungspulsgenerator nach Anspruch 1, **dadurch gekennzeichnet, dass** der Spiral-Puls-Generator aus mehreren Schichten aufgebaut ist, wobei die Anzahl n der Schichten mindestens n = 5 beträgt.

5. Hochspannungspulsgenerator nach Anspruch 4, **dadurch gekennzeichnet, dass** die Anzahl n der Schichten höchstens n = 500 beträgt.

6. Hochspannungspulsgenerator nach Anspruch 1, **dadurch gekennzeichnet, dass** der Spiral-Puls-Generator in etwa hohlzylindrische Gestalt hat.

7. Hochspannungspulsgenerator nach Anspruch 1, **dadurch gekennzeichnet, dass** die Dielektrizitätskonstante $\varepsilon_r$ des Spiral-Puls-Generators bei mindestens $\varepsilon_r = 10$ liegt.

8. Hochspannungspulsgenerator nach Anspruch 1, **dadurch gekennzeichnet, dass** der Spiral-Puls-Generator aus einem LTCC-Material gefertigt ist.

9. Hochdruckentladungslampe (10) mit einem Entladungsgefäß (11), das in einem Außenkolben (12) untergebracht ist, wobei eine Zündeinheit in der Lampe integriert ist, die Hochspannungspulse in der Lampe erzeugt, **dadurch gekennzeichnet, dass** die Zündeinheit im Außenkolben (12) untergebracht ist, wobei die Zündeinheit ein Spiral-Puls-Generator (13) gemäß einem der vorhergehenden Ansprüche ist.

10. Hochdruckentladungslampe nach Anspruch 9, **dadurch gekennzeichnet, dass** die Zündeinheit durch ein Gestell (26, 27) gehaltert ist, das insbesondere auch den Außenkolben haltert.

11. Hochdruckentladungslampe nach Anspruch 9, **dadurch gekennzeichnet, dass** die vom Spiral-Puls-Generator vermittelte Hochspannung direkt auf zwei Elektroden im Entladungsgefäß wirkt.

12. Hochdruckentladungslampe nach Anspruch 9, **dadurch gekennzeichnet, dass** die vom Spiral-Puls-Generator vermittelte Spannung auf eine außen am Entladungsgefäß angebrachte Zündhilfs-Elektrode (14) wirkt.

13. Hochdruckentladungslampe nach Anspruch 9, **dadurch gekennzeichnet, dass** im Außenkolben außerdem ein Vorwiderstand (24) untergebracht ist, der den Ladestrom des Spiral-Puls-Generators begrenzt.

14. Zündeinheit (31) auf Basis eines Hochspannungspulsgenerators nach Anspruch 1, **dadurch gekennzeichnet, dass** sie weiterhin zumindest einen Ladewiderstand (24) und einen Schalter (23) umfasst.

**Claims**

1. High-voltage pulse generator based on a spiral pulse generator (1), **characterized in that** the spiral pulse generator (1) is made from heat-resistant material, wherein this material comprises ceramic films and metallic wetting agent on the films, and wherein the material of the ceramic films is a mixture of two materials, of which the first material has a relative permittivity $\varepsilon_r$ of 2 to 1000 and the second material has a relative permeability $\mu_r$ of 1 to 5000.

2. High-voltage pulse generator according to Claim 1, **characterized in that** the relative permeability of the second material is at least $\mu_r = 1.5$.

3. High-voltage pulse generator according to Claim 1, **characterized in that** the second material is a metal oxide, in particular with a proportion of at least 15% by weight of the ceramic mixture.

4. High-voltage pulse generator according to Claim 1, **characterized in that** the spiral pulse generator is constructed from a plurality of layers, wherein the number n of layers is at least n = 5.

5. High-voltage pulse generator according to Claim 4, **characterized in that** the number n of layers is at most n = 500.

6. High-voltage pulse generator according to Claim 1, **characterized in that** the spiral pulse generator has an approximately hollow-cylindrical form.

7. High-voltage pulse generator according to Claim 1, **characterized in that** the relative permittivity $\varepsilon_r$ of the spiral pulse generator is at least $\varepsilon_r = 10$.

8. High-voltage pulse generator according to Claim 1, **characterized in that** the spiral pulse generator is made from an LTCC material.

9. High-pressure discharge lamp (10) with a discharge vessel (11), which is accommodated in an outer bulb (12), wherein a starting unit, which generates high-voltage pulses in the lamp, is integrated into the lamp, **characterized in that** the starting unit is accommodated in the outer bulb (12), wherein the starting unit is a spiral pulse generator (13) according to one of the preceding claims.

10. High-pressure discharge lamp according to Claim 9, **characterized in that** the starting unit is held by a frame (26, 27) which in particular also holds the outer bulb.

11. High-pressure discharge lamp according to Claim 9, **characterized in that** the high voltage imparted by the spiral pulse generator acts directly on two electrodes in the discharge vessel.

12. High-pressure discharge lamp according to Claim 9, **characterized in that** the voltage imparted by the spiral pulse generator acts on an auxiliary starting electrode (14) fitted to the outside of the discharge vessel.

13. High-pressure discharge lamp according to Claim 9, **characterized in that** a series resistor (24), which limits the charging current of the spiral pulse generator, is also accommodated in the outer bulb.

14. Starting unit (31) based on a high-voltage pulse generator according to Claim 1, **characterized in that** it additionally comprises at least one series resistor (24) and one switch (23).

**Revendications**

1. Générateur d'impulsions haute tension sur la base d'un générateur d'impulsions en spirale (1), **caractérisé en ce que** le générateur d'impulsions en spirale (1) est réalisé en une matière thermostable, cette matière étant composée de feuilles céramiques et d'un mouillage métallique sur les feuilles et la matière des feuilles céramiques étant un mélange de deux matières dont la première a une constante diélectrique $\varepsilon_r$ de 2 à 1000 et la deuxième, une perméabilité relative $\mu_r$ de 1 à 5000.

2. Générateur d'impulsions haute tension selon la revendication 1, **caractérisé en ce que** la perméabilité relative de la deuxième matière est d'au moins $\mu_r = 1,5$.

3. Générateur d'impulsions haute tension selon la revendication 1, **caractérisé en ce que** la deuxième matière est un oxyde de métal, en particulier avec une fraction d'au moins 15 % en poids du mélange céramique.

4. Générateur d'impulsions haute tension selon la revendication 1, **caractérisé en ce que** le générateur d'impulsions en spirale est réalisé à partir de plusieurs couches, le nombre de couches n étant d'au moins n = 5.

5. Générateur d'impulsions haute tension selon la revendication 4, **caractérisé en ce que** le nombre de couches n est de n = 500 au maximum.

6. Générateur d'impulsions haute tension selon la revendication 1, **caractérisé en ce que** le générateur d'impulsions en spirale se présente sensiblement sous la forme d'un cylindre creux.

7. Générateur d'impulsions haute tension selon la revendication 1, **caractérisé en ce que** la constante diélectrique $\varepsilon_r$ du générateur d'impulsions en spirale est d'au moins $\varepsilon_r = 10$.

8. Générateur d'impulsions haute tension selon la revendication 1, **caractérisé en ce que** le générateur d'impulsions en spirale est réalisé à partir d'un matériau LTCC.

9. Lampe à décharge à haute pression (10) avec une enceinte de décharge (11) qui est logée dans une ampoule extérieure (12), une unité d'amorçage qui génère des impulsions haute tension dans la lampe étant intégrée à la lampe, **caractérisée en ce que** l'unité d'amorçage est logée dans l'ampoule extérieure (12), l'unité d'amorçage étant un générateur d'impulsions en spirale (11) selon l'une des revendications précédentes.

**10.** Lampe à décharge à haute pression selon la revendication 9, **caractérisée en ce que** l'unité d'amorçage est maintenue par un support (26, 27) qui maintient notamment aussi l'ampoule extérieure.

**11.** Lampe à décharge à haute pression selon la revendication 9, **caractérisée en ce que** la haute tension fournie par le générateur d'impulsions en spirale agit directement sur deux électrodes dans l'enceinte de décharge.

**12.** Lampe à décharge à haute pression selon la revendication 9, **caractérisée en ce que** la tension fournie par le générateur d'impulsions en spirale agit sur une électrode d'aide à l'amorçage (14) montée à l'extérieur sur l'enceinte de décharge.

**13.** Lampe à décharge à haute pression selon la revendication 9, **caractérisée en ce qu'**est en outre logée, dans l'ampoule extérieure, une résistance ballast (24) qui limite le courant de charge du générateur d'impulsions en spirale.

**14.** Unité d'amorçage (31) sur la base d'un générateur d'impulsions haute tension selon la revendication 1, **caractérisée en ce qu'**elle comprend en outre au moins une résistance de charge (24) et un commutateur (23).

FIG 1

FIG 2

FIG 3

FIG 4

28 —

22 —

26 —

— 27

— 20

— 31

— 29

— 30

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3289015 A
- US 4325004 A
- US 4353012 A
- EP 49465 A2
- US 20030001519 A
- US 6853151 B

**In der Beschreibung aufgeführte Nicht-Patentliteratur**

- **STURM ; KLEIN.** Betriebsgeräte und Schaltungen für elektrische Lampen. 1992, 193-195